# EUROPEAN PATENT APPLICATION

(11) **EP 1 699 277 A1**
(43) Date of publication of application: **06.09.2006**
(21) Application number: 04792430.3
(22) Date of filing: 15.10.2004
(51) Int. Cl.: H05K 3/46

(54) **CERAMIC MULTILAYER SUBSTRATE**

(30) Priority: 26.12.2003 JP 2003434347
(71) Applicant: MURATA MANUFACTURING CO., LTD., Nagaokakyo-shi, Kyoto 617-8555 (JP)
(72) Inventor: SAKAI, Norio, Murata Manufacturing Co., Ltd., Nagaokakyo-shi, Kyoto 617-8555 (JP); HARADA, Jun, Murata Manufacturing Co., Ltd., Nagaokakyo-shi, Kyoto 617-8555 (JP); ISHINO, Satoshi, Murata Manufacturing Co., Ltd., Nagaokakyo-shi, Kyoto 617-8555 (JP); NISHIZAWA, Y., Murata Manufacturing Co., Ltd., Nagaokakyo-shi, Kyoto 617-8555 (JP)
(74) Representative: Schoppe, Fritz
(86) International application number: PCT/JP2004/015213
(87) International publication number: WO 2005/067359

(57) **Abstract**

A ceramic multilayer substrate is provided with a ceramic laminate (10) including a plurality of ceramic layers laminated, having a first main surface (18), and including internal circuit elements disposed in the inside; a resin layer (15) having a bonding surface (19) in contact with the first main surface (18) of the above-described ceramic laminate (10) and a mounting surface (16) opposite to the above-described bonding surface (19); external electrodes (17), each disposed on the mounting surface (16) of the above-described resin layer (15) and electrically connected to at least one of the internal circuit elements (14) of the above-described ceramic laminate (10); and a ground electrode (12), a dummy electrode, or capacitor-forming electrodes disposed at an interface between the first main surface (18) of the above-described ceramic laminate (10) and the bonding surface (19) of the above-described resin layer (15) or in the inside of the above-described resin layer (15).

## Description

### Technical Field

The present invention relates to a ceramic multilayer substrate.

### Background Art

Various high-frequency modules, e.g., chip antennas, delay lines, high-frequency combination switch modules, and receiving devices, are mounted in the inside of information communications apparatuses, e.g., portable terminals. Such a high-frequency module is used in the condition of being mounted on a wiring substrate.

In general, circuit components are mounted on a multilayer substrate in such a high-frequency module. Multilayer substrates composed of ceramic multilayer substrates are well-known. Most of ceramic multilayer substrates are provided with ground electrodes in order to eliminate noise. This is disclosed in Japanese Unexamined Patent Application Publication No. 2002-94410 (Patent Document 1), for example.

In general, ground electrodes are built in the inside of ceramic multilayer substrates at positions as close to bottom surfaces as possible. This is because unnecessary impedance components, e.g., stray capacitances and stray inductances, are readily eliminated by bringing the ground electrodes as close to ground electrodes of wiring substrates as possible.

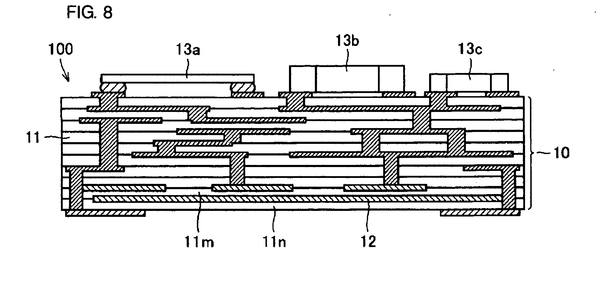

Fig. 8 shows an example of known ceramic multilayer substrates. In a ceramic multilayer substrate 100, electronic components 13a, 13b, and 13c are mounted on a ceramic laminate 10 composed of ceramic layers 11 laminated. A ground electrode 12 is built in the vicinity of a bottom surface of the ceramic multilayer substrate 100 while being sandwiched between ceramic layers 11m and 11n.
Patent Document 1: Japanese Unexamined Patent Application Publication No. 2002-94410

### Disclosure of Invention

### Problems to be Solved by the Invention

The ground electrode requires a wide area and, therefore, a conductor pattern having a wide area must be formed on a ceramic green sheet in the production of a ceramic multilayer substrate. However, as the area of the conductor pattern is increased, the mutual contact area of the two ceramic green sheets sandwiching the conductor pattern therebetween is decreased. As a result, the bondability between the ceramic green sheets is reduced.

As for the example, the ceramic multilayer substrate 100, shown in Fig. 8, the bondability between the ceramic green sheets 11m and 11n is reduced due to an increase in the area of the ground electrode 12 sandwiched by the ceramic green sheets 11m and 11n.

Furthermore, the ceramic layers are loaded due to the difference in the amount of shrinkage between the conductor pattern and the ceramic green sheets occurred during baking. This load exerts a larger effect as the area of the conductor pattern is increased. Consequently, there is a problem in that inconveniences, e.g., delamination and crack, of the ceramic layers are present particularly in the vicinity of the ground electrode of the ceramic multilayer substrate after baking.

In order to overcome this problem, there is an idea that the ground electrode is disposed while being exposed at the bottom surface of the ceramic multilayer substrate. This structure has been in practical use. However, in that case, another problem occurs in that a short circuit tends to occur between the ground electrode and wirings on the wiring substrate.

Accordingly, it is an object of the present invention to provide a ceramic multilayer substrate, wherein a ground electrode can be disposed at a position in extremely close proximity to a wiring substrate without occurrence of short circuit between the ground electrode and the wiring substrate even when the ceramic multilayer substrate is mounted on the surface of the wiring substrate and, in addition, inconveniences, e.g., crack, do not occur during the baking.

### Means for solving the Problems

In order to achieve the above-described object, a ceramic multilayer substrate according to a first aspect of the present invention is provided with a ceramic laminate including a plurality of ceramic layers laminated, having a first main surface, and including internal circuit elements disposed in the inside; a resin layer having a bonding surface in contact with the first main surface of the above-described ceramic laminate and a mounting surface opposite to the above-described bonding surface; external electrodes, each disposed on the mounting surface of the above-described resin layer and electrically connected to at least one of the internal circuit elements of the above-described ceramic laminate; and a ground electrode, a dummy electrode, or capacitor-forming electrodes disposed at an interface between the first main surface of the above-described ceramic laminate and the bonding surface of the above-described resin layer or in the inside of the above-described resin layer. By adopting this configuration, the ground electrode, the dummy electrode, or the capacitor-forming electrodes can be held at the position in extremely close proximity to the mounting surface. As a result, the distance between the ground electrode, the dummy electrode, or the capacitor-forming electrodes and the wiring substrate can be decreased.

In the above aspect, preferably, the above-described ground electrode, the dummy electrode, or the capacitor-forming electrodes are made of a sintered metal integrally baked with the above-described ceramic laminate. By adopting this configuration, the surface roughness of the electrode itself is increased as compared with that in the case where the electrode is formed by attaching metal foil, and the bonding forth can be increased by virtue of an anchor effect with respect to bonding to the resin layer.

In order to achieve the above-described object, a ceramic multilayer substrate according to a second aspect of the present invention is provided with a ceramic laminate including a plurality of ceramic layers laminated, having a first main surface, and including internal circuit elements disposed in the inside; a resin layer having a bonding surface in contact with the first main surface of the above-described ceramic laminate and a mounting surface opposite to the above-described bonding surface; external electrodes, each disposed on the mounting surface of the above-described resin layer and electrically connected to at least one of the internal circuit elements of the above-described ceramic laminate; a ground electrode disposed at an interface between the first main surface of the above-described ceramic laminate and the bonding surface of the above-described resin layer or in the inside of the above-described resin layer; and capacitor-forming electrodes facing the above-described ground electrode from the side opposite to the above-described mounting surface so that capacitors are constructed by the above-described ground electrode and the capacitor-forming electrodes. By adopting this configuration, capacitors having very stable characteristics can be produced.

In the above-described aspect, preferably, first circuit components mounted on the above-described first main surface and covered with the above-described resin layer are provided, wherein the above-described ground electrode, the dummy electrode, or the capacitor-forming electrodes are disposed on the side nearer to the above-described mounting surface than are the above-described first circuit components. By adopting this configuration, the electronic components can be mounted not only on the top surface of the ceramic laminate, but also on the bottom surface. Consequently, an increase in the density of electronic components and space saving of wiring substrates can be achieved.

In the above-described aspect, preferably, the above-described first circuit components are disposed within the region determined by projecting the above-described ground electrode, the dummy electrode, or the capacitor-forming electrodes on the above-described first main surface. By adopting this configuration, the ground electrode can exert a shielding effect on the first circuit components.

In the above-described aspect, preferably, the electrical connections from the above-described external electrodes to the above-described internal circuit elements are performed through relay electrodes disposed to extend along the above-described first main surface. By adopting this configuration, the position of an upper via and the position of a lower via can be shifted from each other. Therefore, the flexibility in the design can be increased.

In the above-described aspect, preferably, the above-described ceramic laminate has a second main surface on the side opposite to the above-described first main surface, and second circuit components are mounted on the above-described second main surface. By adopting this configuration, an increase in the density of electronic components and space saving of wiring substrates can be achieved.

In the above-described aspect, preferably, a conductor case is disposed on the above-described second main surface to cover the above-described second circuit components. By adopting this configuration, since the second circuit components are covered with the conductor case, the second circuit components are shielded against external electromagnetic waves, and leakage of electromagnetic waves generated from the second circuit components to the outside can also be prevented.

In the above-described aspect, preferably, the above-described second circuit components on the above-described second main surface are covered with a molded resin layer (25). By adopting this configuration, the second circuit components are protected from, for example, collision with other components.

### Advantages

According to the present invention, the ground electrode can be held at the position in extremely close proximity to the mounting surface. As a result, the distance between the ground electrode and the wiring substrate can be decreased. Since the necessity for any ceramic layer under the ground electrode can be avoided, it is possible to prevent the problem that delamination or crack occurs in the ceramic layers under the ground electrode during baking. Furthermore, since the ground electrode is covered with the resin layer, occurrence of short circuit between the ground electrode and the electrode of the wiring substrate can be prevented even when this ceramic multilayer substrate is mounted on the surface of the wiring substrate.

### Brief Description of the Drawings

[Fig. 1] Fig. 1 is a sectional view of a ceramic multilayer substrate in a first embodiment according to the present invention.
[Fig. 2] Fig. 2 is a sectional view of a ceramic multilayer substrate in a second embodiment according to the present invention.
[Fig. 3] Fig. 3 is a sectional view of a ceramic multilayer substrate in a third embodiment according to the present invention.
[Fig. 4] Fig. 4 is a sectional view of a ceramic multilayer substrate in a fourth embodiment according to the present invention.
[Fig. 5] Fig. 5 is a sectional view of a ceramic multilayer substrate in a fifth embodiment according to the present invention.
[Fig. 6] Fig. 6 is a sectional view of another example of the ceramic multilayer substrate in the fifth embodiment according to the present invention.
[Fig. 7] Fig. 7 is a sectional view of a ceramic multilayer substrate in a sixth embodiment according to the present invention.
[Fig. 8] Fig. 8 is a sectional view of a ceramic multilayer substrate according to a known technology.

### Reference Numerals

10 ceramic laminate, 11 ceramic layer, 12 ground electrode, 13a, 13b, and 13c electronic component, 14 internal circuit element, 15 resin layer, 16 mounting surface, 17 external electrode, 18 first main surface, 19 bonding surface, 20 capacitor-forming electrode, 21 relay electrode, 22a, 22b, and 22c electronic component, 23 second main surface, 24 conductor case, 25 molded resin layer, 100, 101, 102, 103, and 104 ceramic multilayer substrate.

### Best Mode for Carrying Out the Invention

Hereafter, the concept of upper or lower do not refer to absolutely upper or lower, but refer to upper or lower relative to apparent positions shown in the reference drawing.

### (First embodiment)

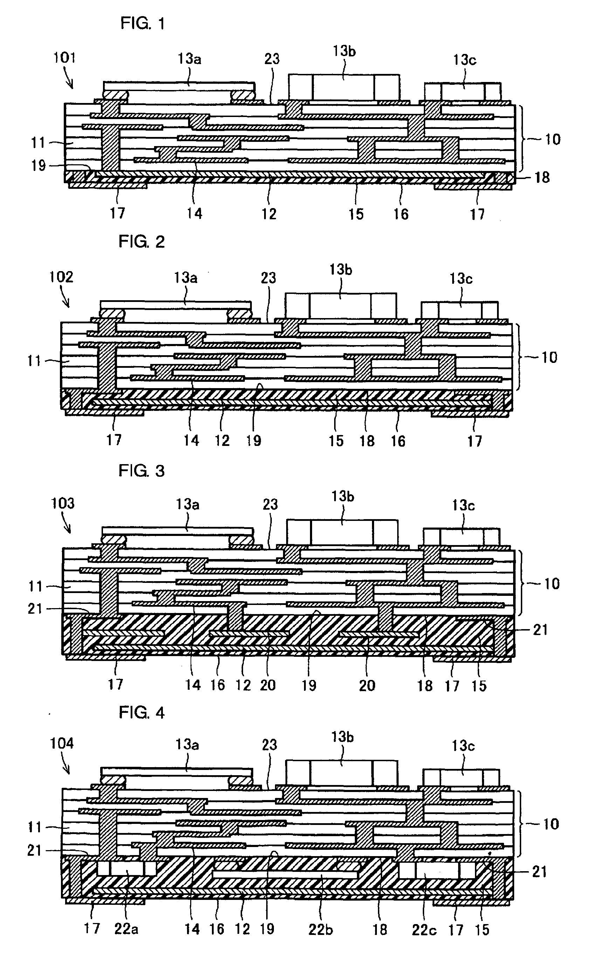

A ceramic multilayer substrate 101 in the first embodiment according to the present invention will be described with reference to Fig. 1. This ceramic multilayer substrate 101 is provided with a ceramic laminate 10 composed of a plurality of ceramic layers 11 laminated. Internal circuit elements 14 are disposed in the inside of the ceramic laminate 10. The internal circuit elements 14 includes via hole conductors penetrating ceramic layers 11 in a direction of lamination and in-plane conductors disposed at interfaces between the ceramic layers 11. The ceramic laminate 10 has a bottom surface serving as a first main surface 18. A ground electrode 12 is disposed to cover the first main surface 18 of the ceramic laminate 10. Furthermore, a resin layer 15 is disposed to cover the ground electrode 12.

The resin layer 15 has a bonding surface 19 in contact with the first main surface 18 and a mounting surface 16 opposite to the bonding surface 19. External electrodes 17 are disposed on the mounting surface 16. That is, in the present embodiment, the ground electrode 12 is disposed at the interface between the first main surface 18 of the ceramic laminate 10 and the bonding surface 19 of the resin layer 15.

The external electrode 17 is electrically connected to at least one of the internal circuit elements 14 through a via hole disposed in the resin layer 15. Some external electrodes 17 do not seem to be connected to any internal circuit element 14 in the drawing. However, these are connected to respective internal circuit elements 14 at positions not shown in this section. The ceramic laminate 10 has a top surface serving as a second main surface 23 opposite to the first main surface 18. Electronic components 13a, 13b, and 13c are mounted on the second main surface 23.

The ceramic layer 11 can be formed from a ceramic material capable of being sintered at a low temperature. The ceramic material capable of being sintered at a low temperature refers to a ceramic material which can be baked at a temperature of 1,000°C or less. Examples thereof can include glass composite materials produced by mixing a ceramic powder, e.g., alumina, forsterite, or cordierite, with borosilicate glass or the like, crystallized glass materials composed of ZnO-MgO-Al₂O₃-SiO₂ base crystallized glass, and non-glass materials composed of, e.g., BaO-Al₂O₃₋SiO₂ base ceramic powders and Al₂O₃-CaO-SlO₂-MgO-B₂O₃ base ceramic powders. The ceramic layers 11 are composed of ceramic material capable of being sintered at a low temperature and, thereby, low resistance and low melting point metallic materials, e.g., Ag or Cu, can be used as a metallic material constituting the internal circuit elements 14 in the ceramic laminate 10. Consequently, the ceramic laminate 10 and the internal circuit elements 14 disposed therein can be produced by simultaneous baking at 1,000°C or less.

Preferably, the ground electrode 12 disposed between the first main surface 18 of the ceramic laminate 10 and the bonding surface 19 of the resin layer 15 is formed to constitute within the range of 3% to 98% of the area of the first main surface 18, and more preferably of 40% to 95%. This is because the bonding forth of the resin layer described below is increased. The thickness of the resin layer 15 is 5 to 500 µm, and preferably is 10 to 300 µm. The thickness may be smaller than the thickness of the ceramic laminate 10. This is because the connection distance from the ground electrode of the mother substrate is decreased and, thereby, the value of parasitic inductance can be decreased, so that excellent high-frequency characteristics can be exerted particularly in applications at high frequencies.

The ground electrode 12 may be an electrode made of metal foil, e.g., copper foil, but preferably is an electrode made of a sintered metal. In general, the surface of the ceramic laminate 10 has a surface roughness Rmax at the same level as that of common copper foil. That is, the Rmax is a few micrometers and, therefore, the bonding forth to the resin layer 15 is weak. Since the surface roughness Rmax of the sintered metal is a several tens of micrometers, and is an order of magnitude larger than the surface roughness Rmax of the copper foil of a few micrometers, when the ground electrode 12 made of the sintered metal is interposed between the ceramic laminate 10 and the resin layer 15, the bonding strength between the ground electrode 12 and the resin layer 15 can be increased by the anchor effect of the sintered metal. The above-described difference in the surface roughness results from that the copper foil is formed by plating or rolling of a copper plate whereas the sintered metal is formed by baking a conductive paste containing 10 to 40 percent by volume of resin referred to as varnish, the resin component is burnt off to leave voids in the inside or on the surface and, thereby, the surface roughness is increased.

The ground electrode 12 is an electrode which is at a ground potential (earth potential). Other electrodes may be disposed in place of the ground electrode 12. In that case, it is essential only that the electrode taking the place of the ground electrode 12 is an electrode having a large area as described above. For example, the electrode may be a dummy electrode electrically independent of the internal circuit elements 14, or be a capacitor-forming electrode to form a capacitor in combination with any other electrode.

The ceramic multilayer substrate 101 in the present embodiment can be produced as described below.

A conductive paste is patterned on a ceramic green sheet and, thereby, a predetermined conductor pattern to become internal circuit elements 14 is formed on the ceramic green sheet. Likewise, a plurality of ceramic green sheets having predetermined conductor patterns are produced. The plurality of ceramic green sheets are laminated while sandwiching the conductor patterns therebetween. A conductor pattern to become the ground electrode 12 is formed on the back of the thus produced unbaked laminate to become the ceramic laminate 10. Alternatively, a conductor pattern to become the ground electrode 12 is formed on a ceramic green sheet, the resulting ceramic green sheet is laminated and, thereby, unbaked laminate having the conductor pattern to become the ground electrode 12 can be produced.

The thus produced structure is baked. As a result, the unbaked laminate is converted to the ceramic laminate 10 which is made of a sintered ceramic, and the conductor pattern to become the ground electrode is converted to the ground electrode 12 made of a sintered metal.

Furthermore, a resin sheet in a semi-hardened state, that is, in a state of B stage, is laminated to cover the ground electrode 12, followed by curing, so that the resin layer 15 is produced. Through holes are bored in the resin layer 15 with a laser or the like, and are filled in with an electrically conductive material, e.g., an electrically conductive resin or solder. Alternatively, a resin sheet having through holes filled in with an electrically conductive material in advance may be laminated. Subsequently, electrodes are formed from metal foil or the like on the surface of the resin layer 15, so that the external electrodes 17 are produced. With respect to the external electrodes 17, end surfaces of the conductive materials disposed in the resin layer may be used as external electrodes. On the other hand, surface-mount electronic components 13a, 13b, and 13c, e.g., semiconductor devices and chip type monolithic capacitors, are mounted on the top surface of the ceramic laminate 10. In this manner, the ceramic multilayer substrate 101 shown in Fig. 1 can be produced.

In the present embodiment, the ground electrode 12 can be held at a position in extremely close proximity to the mounting surface 16. That the ground electrode 12 is close to the mounting surface 16 refers to that the ground electrode 12 becomes close to the wiring substrate (not shown in the drawing), e.g., a mother board, during mounting. In the present embodiment, since no ceramic layer is disposed under the ground electrode 12, it is possible to prevent the problem that delamination or crack occurs in ceramic layers under the ground electrode during baking. Furthermore, since the ground electrode 12 is covered with the resin layer 15, occurrence of short circuit between the ground electrode 12 and the electrode of the wiring substrate can be prevented even when the ceramic multilayer substrate 101 is mounted on the surface of the wiring substrate (not shown in the drawing).

Preferably, the ground electrode 12 is made of a sintered metal integrally baked with the ceramic laminate 10. This is because when the electrode is integrally baked, the bonding forth between the ceramic laminate 10 and the ground electrode 12 is increased and, in addition, since the surface roughness of the electrode itself is increased as compared with that in the case where the electrode is formed by attaching metal foil, e.g., copper foil, the bonding forth can be increased by virtue of an anchor effect with respect to bonding to the resin layer 15, as described above.

### (Second embodiment)

A ceramic multilayer substrate 102 in the second embodiment according to the present invention will be described with reference to Fig. 2. In this ceramic multilayer substrate 102, the ground electrode 12 is disposed while avoiding contact with the first main surface 18. That is, the ground electrode 12 is disposed in the inside of the resin layer 15, and is disposed while being sandwiched by the resin layer 15 from above and below. The configurations of the other portions are similar to those described in the first embodiment.

In the present embodiment, there is no portion in which the ground electrode 12 and the ceramic layer 11 are in direct contact with each other, and therefore, problems, e.g., crack resulting from the difference in heat shrinkage behavior between the ground electrode 12 and the ceramic layer 11 can be further reliably avoided.

The structure shown in Fig. 2 can be constructed by laminating resin sheets over a plurality of times to form the resin layer 15, and inserting copper foil between the sheets. The copper foil interposed in the inside of the resin layer 15 serves as the ground electrode 12.

### (Third embodiment)

A ceramic multilayer substrate 103 in the third embodiment according to the present invention will be ' described with reference to Fig. 3. In this ceramic multilayer substrate 103, the capacitor-forming electrodes 20 are disposed in addition to the ground electrode 12 on the surface of an internal layer of the resin layer 15. The capacitor-forming electrodes 20 are electrodes which face the ground electrode 12 from the side opposite to the mounting surface 16 and, thereby, construct capacitors in combination with the ground electrode 12. These capacitors are electrically connected to the internal circuit elements 14 to constitute predetermined circuits. The configurations of the other portions are similar to those described in the second embodiment. The capacitor-forming electrodes 20 may be disposed at the interface between the ceramic laminate 10 and the resin layer 15.

In this ceramic multilayer substrate 103, the capacitors are formed by the capacitor-forming electrodes 20 and the ground electrode 12. In this manner, capacitors having very stable characteristics can be produced.

### (Fourth embodiment)

A ceramic multilayer substrate 104 in the fourth embodiment according to the present invention will be described with reference to Fig. 4. In this ceramic multilayer substrate 104, surface-mount electronic components 22a, 22b, and 22c, such as semiconductor devices and chip type monolithic capacitors, are surface-mounted as first circuit components on the first main surface 18 which is the bottom surface of the ceramic laminate 10. The resin layer 15 is formed to cover the electronic components 22a, 22b, and 22c. The ground electrode 12 is disposed on the side nearer to the mounting surface 16 than are the electronic components 22a, 22b, and 22c, that is, below the electronic components. The configurations of the other portions are similar to those described in the second embodiment.

In the present embodiment, the electronic components can be mounted not only on the top surface of the ceramic laminate 10, but also on the bottom surface. Consequently, an increase in the density of electronic components and space saving of wiring substrates can be achieved.

In particular, as shown in Fig. 4, preferably, the electronic components 22a, 22b, and 22c serving as the first circuit components are disposed within the region determined by projecting the ground electrode 12 on the first main surface 18. This is because the ground electrode 12 exerts a shielding effect on the first circuit components by adopting such a configuration.

As shown in Fig. 3 and Fig. 4, the ceramic multilayer substrates 103 and 104 are provided with relay electrodes 21 disposed to extend along the first main surfaces 18. The electrical connection from the external electrode 17 to the internal circuit element 14 is performed through the relay electrode 21. There is an idea that the electrical connection from the external electrode 17 to the internal circuit element 14 is performed by direct via-to-via connection. However, it is preferable to interpose the relay electrode 21, as shown in Fig. 3 and Fig. 4, since the position of an upper via and the position of a lower via can be shifted from each other and, therefore, the flexibility in the design can be increased. This is not limited to the ceramic multilayer substrates 103 and 104 in the third and fourth embodiments. The same holds true in the other embodiments.

As is shown in each of the above-described embodiments, preferably, the second main surface 23 is disposed on the side opposite to the first main surface 18, and surface-mount electronic components 13a, 13b, and 13c, such as semiconductor devices and chip type monolithic capacitors, are mounted as second circuit components on the second main surface 23. This is because a multifunctional high-frequency module can be constructed by adopting such a configuration.

### (Fifth embodiment)

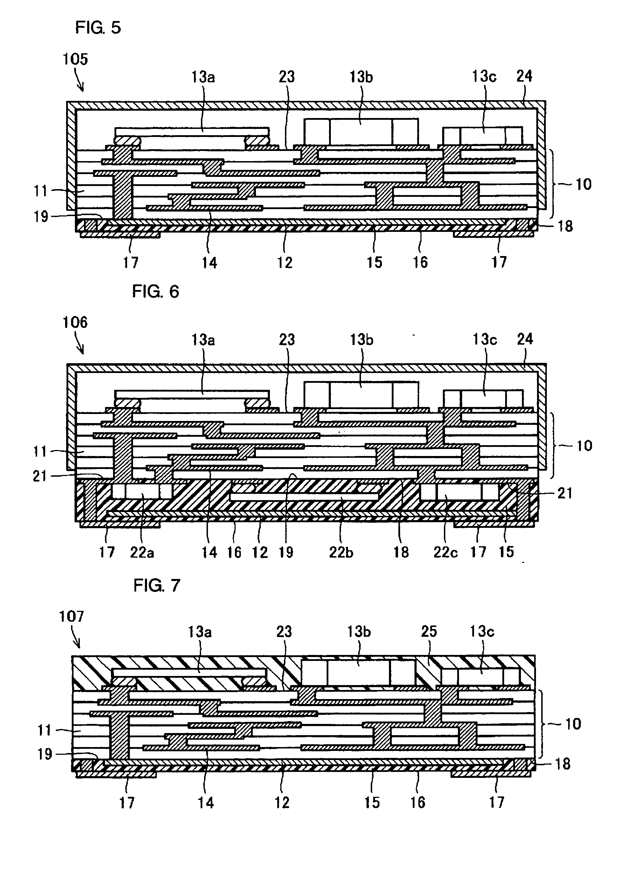

A ceramic multilayer substrate 105 in the fifth embodiment according to the present invention will be described with reference to Fig. 5. This ceramic multilayer substrate 105 corresponds to the ceramic multilayer substrate 101 in the first embodiment, in which a conductor case 24 is attached to cover the electronic components 13a, 13b, and 13c serving as the second circuit components mounted on the second main surface 23.

In the present embodiment, since the second circuit components are covered with the conductor case 24, the second circuit components are shielded against external electromagnetic waves, and leakage of electromagnetic waves generated from the second circuit components to the outside can also be prevented. Therefore, this is preferable.

The present embodiment was described with reference to the example based on the ceramic multilayer substrate 101 in the first embodiment. However, as shown in Fig. 6, the conductor case 24 may be attached to the ceramic multilayer substrate 104 in the fourth embodiment. Alternatively, the conductor case 24 may be attached to the ceramic multilayer substrate in the second embodiment or the third embodiment.

### (Sixth embodiment)

A ceramic multilayer substrate 107 in the sixth embodiment according to the present invention will be described with reference to Fig. 7. This ceramic multilayer substrate 107 corresponds to the ceramic multilayer substrate 101 in the first embodiment, in which a molded resin layer 25 is disposed to cover the electronic components 13a, 13b, and 13c serving as the second circuit components mounted on the second main surface 23. Therefore, the detailed configurations of the other portions are similar to those described in the first embodiment.

In the present embodiment, since the second circuit components are covered with the conductor case 24, the second circuit components are protected from, for example, collision with other components. The present embodiment was described with reference to the example based on the ceramic multilayer substrate 101 in the first embodiment. In addition to this, the conductor case 24 may be attached to any one of the ceramic multilayer substrates in the second, third, and fourth embodiments.

Every embodiment disclosed in the above-described present specification is no more than an exemplification. The scope of the present invention is not limited to the above description, but is indicated by the claims. The present invention includes any spirit and scope equivalent to those of the claims and all modifications within the scope of the claims.

### Industrial Applicability

The present invention can be applied to ceramic multilayer substrates generally used for high-frequency modules mounted in the inside of information communications apparatuses, for example.

## Claims

1. A ceramic multilayer substrate comprising:
a ceramic laminate (10) including a plurality of ceramic layers, having a first main surface (18), and including internal circuit elements disposed in the inside of the laminate;
a resin layer (15) having a bonding surface (19) in contact with the first main surface (18) of the ceramic laminate (10) and a mounting surface (16) opposite to the bonding surface (19);
external electrodes (17), each disposed on the mounting surface (16) of the resin layer (15) and electrically connected to at least one of the internal circuit elements (14) of the ceramic laminate (10); and
a ground electrode (12), a dummy electrode, or capacitor-forming electrode disposed at an interface between the first main surface (18) of the ceramic laminate (10) and the bonding surface (19) of the resin layer (15) or in the inside of the resin layer (15).

2. The ceramic multilayer substrate according to Claim 1, wherein the ground electrode (12), the dummy electrode, or the capacitor-forming electrode comprises a sintered metal integrally baked with the ceramic laminate.

3. A ceramic multilayer substrate comprising:
a ceramic laminate (10) including a plurality of ceramic layers, having a first main surface (18), and including internal circuit elements disposed in the inside of the laminate;
a resin layer (15) having a bonding surface (19) in contact with the first main surface (18) of the ceramic laminate (10) and a mounting surface (16) opposite to the bonding surface (19);
external electrodes (17), each disposed on the mounting surface (16) of the resin layer (15) and electrically connected to at least one of the internal circuit elements (14) of the ceramic laminate (10);
a ground electrode (12) disposed at an interface between the first main surface (18) of the ceramic laminate (10) and the bonding surface (19) of the resin layer (15) or in the inside of the resin layer (15); and
a capacitor-forming electrode (20) facing the ground electrode (12) from the side opposite to the mounting surface (16) so that a capacitor is constructed by the ground electrode (12) and the capacitor-forming electrode (20).

4. The ceramic multilayer substrate according to Claim 1, comprising a first circuit component (22a, 22b, and 22c) mounted on the first main surface (18) and covered with the resin layer (15), wherein the ground electrode (12), the dummy electrode, or the capacitor-forming electrodes are disposed on the side nearer to the mounting surface (16) than are the first circuit component (22a, 22b, and 22c).

5. The ceramic multilayer substrate according to Claim 4, wherein the first circuit component (22a, 22b, and 22c) is disposed within the region determined by projecting the ground electrode (12), the dummy electrode, or the capacitor-forming electrode on the first main surface (18).

6. The ceramic multilayer substrate according to Claim 1, wherein the electrical connections from the external electrodes (17) to the internal circuit elements (14) are performed through relay electrodes (21) disposed to extend along the first main surface (18).

7. The ceramic multilayer substrate according to Claim 1, wherein the ceramic laminate (10) comprises a second main surface (23) on the opposite side to the first main surface (18), and a second circuit component (13a, 13b, and 13c) is mounted on the second main surface (23).

8. The ceramic multilayer substrate according to Claim 7, wherein a conductive case (24) is disposed on the second main surface (23) to cover the second circuit component (13a, 13b, and 13c).

9. The ceramic multilayer substrate according to Claim 7, wherein the second circuit component (13a, 13b, and 13c) on the second main surface (23) is covered with a molded resin layer (25).
